# EUROPÄISCHE PATENTSCHRIFT

(11) **EP 0 688 053 B1**
(45) Veröffentlichungstag und Bekanntmachung des Hinweises auf die Patenterteilung: **13.01.1999**
(21) Anmeldenummer: 95201442.1
(22) Anmeldetag: 01.06.1995
(51) Int. Cl.: H01L 25/07, H01L 25/065, H01L 23/473

(54) **Niederinduktives Leistungshalbleitermodul**
Low inductance power semiconductor module
Module semi-conducteur de puissance à basse inductance

(30) Priorität: 17.06.1994 DE 4421319
(43) Veröffentlichungstag der Anmeldung: 20.12.1995
(73) Patentinhaber: ASEA BROWN BOVERI AG, 5400 Baden (CH)
(72) Erfinder: Bayerer, Reinhold, Dr., D-64385 Reichelsheim (DE); Stockmeier, Thomas, Dr., Rancho Palos Verdes, CA 90274 (US)

(56) Entgegenhaltungen:
- EP-A- 0 228 953
- EP-A- 0 427 143
- EP-A- 0 551 741
- US-A- 4 989 070
- 1993 PROC. 43RD ELECTRONIC COMPONENTS & TECHNOLOGY CONFERENCE, Juni 1993, FLORIDA, US Seiten 22 - 31 R. NARAYANAN ET AL. 'thermal and mechanical analysis of flip-chips on a liquid-cooled multichip module'
- PATENT ABSTRACTS OF JAPAN vol. 9, no. 251 (E-348) (1974) 8. Oktober 1985 & JP-A-60 101 958 (ROOMU) 6. Juni 1985

## Beschreibung

### Technisches Gebiet

Die Erfindung bezieht sich auf das Gebiet der Leistungshalbleiterelektronik.

Sie geht aus von einem Leistungshalbleitermodul nach dem Oberbegriff des ersten Anspruchs.

### Stand der Technik

Ein solches Leistungshalbleitermodul wird bereits in der Offenlegungsschrift DE 39 37 045 Al beschrieben.

Ein Leistungshalbleitermodul umfasst in der Regel mehrere Halbleiterbauelemente, die zu einer logischen Funktionseinheit zusammengefasst werden können. Beispiele sind Gleichrichter, Einzelschalter mit antiparalleler Diode oder Phasenbausteine. Module unterscheiden sich von den heute im Hochleistungs-Halbleiterbereich üblichen Scheibenzellen im wesentlichen dadurch, dass Kühlung und Leistungsanschlüsse voneinander elektrisch isoliert sind.

Solche Module (Thyristor-, Transistor, IGBT-, MOSFET-, Dioden-Module) sind heute im Leistungsbereich bis zu 1200 V und einige 100 A weit verbreitet und werden vor allem in Industrieantrieben eingesetzt. Module für hohe Ströme bestehen in der Regel aus einer Anzahl von Einzel-Bausteinen, die im Modul parallelgeschaltet werden, oder es werden gleich mehrere Module parallel geschaltet.

Gegenwärtig sind der Leistungsfähigkeit der Module im Hinblick auf Stromtragfähigkeit und maximale Blockierspannung durch folgende Probleme nach oben hin Grenzen gesetzt:
- Die parasitäre Induktivität des inneren Aufbaus eines Moduls erlaubt nicht, beliebig viele Bauelemente parallel zu schalten. Ein- und Ausschaltvorgänge würden zu unzulässigen Schwingungen führen. Zudem ist die Fläche der einzelnen Bauelemente, die man parallel schaltet, aus Gründen der Herstellungskosten und Zuverlässigkeit nicht beliebig zu steigern.
- Mit zunehmender Modul-Grundfläche steigen die Zuverlässigkeitsprobleme an, speziell im Hinblick auf die zu fordernde Festigkeit gegen Temperaturwechsel, da die mechanische Belastung mit zunehmender Baugrösse und aufgrund der unterschiedlichen thermischen Ausdehnungskoeffizienten der eingesetzten Werkstoffe immer grösser wird.
- Für die für Bauelemente mit hoher Blockierfestigkeit geforderte Isolationsfestigkeit sind in der Regel die mit einem herkömmlichen Modul zu erzielenden Kriechwege zu gering.
- Der thermische Widerstand eines konventionellen Moduls ist im Vergleich zu einem Aufbau mit Scheibenzellen relativ hoch. Der Grund hierfür ist die Trennung des thermischen und des elektrischen Kontaktes, was die Verwendung von Werkstoffen erfordert, die im Vergleich zu Metallen geringe thermische Leitfähigkeit aufweisen und die die Kühlung nur eines der Hauptanschlüsse der Bauelement ermöglicht. In einer Scheibenzelle können beide Hauptelektroden gekühlt werden.
- Ein Modul wird mit Schrauben (typisch an allen vier Ecken) auf eine Kühlplatte oder einen Kühlkörper geschraubt. Für ein sehr grossflächiges Modul kann damit der sichere, thermisch gut leitende Kontakt in der Mitte der Grundfläche problematisch werden und sich während des Betriebes im Laufe der Zeit verändern. - Die Hauptanschlüsse sind bei einem Modul nebeneinander auf der Oberseite des Moduls angeordnet. Damit ist vorgegeben, dass für den Gleichspannungsanschluss eine Stromschleife und damit eine Induktivität entsteht.

In der eingangs erwähnten Offenlegungsschrift DE 39 37 045 von R. Bayerer et al. wird deshalb versucht, die Streuinduktivität zur verringern und eine Geometrie anzugeben, welche für eine grössere Zahl von Leistungstransistoren geeignet ist. Zu diesem Zweck bestehen die drei Hauptanschlussleitungen aus breiten Bändern, die in geringem Abstand zueinander angeordnet sind und aufgrund ihrer geometrische Anordnung eine Anschlussbandleitung bilden. Die vertikal zum Modulboden geführten Leitungen erfordern eine relativ komplizierte Verbindungstechnik und erschweren die ausreichende elektrische Isolation untereinander, insbesondere wenn die Induktivität gering sein soll.

In der Offenlegungsschrift DE 41 03 486 A1 von H.J. Krokoszinksi et al. wird dagegen versucht, die Wärmeabfuhr zu verbessern, indem ein Modul von beiden Seiten gekühlt wird. Nachteilig ist jedoch daran, dass das Kühlmedium auch die Gleichspannungsanschlüsse umspült und somit elektrisch isolierend sein muss (z.B. deionisiertes Wasser). Zudem bilden die Gleichspannungsanschlüsse auch eine Leiterschleife.

"Aus der Europäischen Patentanmeldung EP 0 228 953 ist außerdem ein elektronisches Bauteil mit kreisrunder Oberfläche bekannt, bei dem auf zwei Seiten eines Kühlkörpers Chips angebracht sein können."

Ein weiteres mit einem Kühlkörper vorgesehenes Halfleitermodul ist aus EP-A-0 551 741 bekannt.

### Darstellung der Erfindung

Aufgabe der vorliegenden Erfindung ist es deshalb, ein Leistungshalbleitermodul anzugeben, das für höchste Leistungen geeignet ist bei welchem die vorstehend genannten Probleme gelöst werden.

Diese Aufgabe wird bei einem Leistungshalbleitermodul der eingangs genannten Art durch die Merkmale des ersten Anspruchs gelöst.

Kern der Erfindung ist es also, dass auf beiden Seiten eines Kühlkörpers Leistungshalbleiterbaugruppen vorgesehen sind und dass diese durch ein niederinduktives Kontaktblechpaket kontaktiert werden.

Ein bevorzugtes Ausführungsbeispiel ist dadurch gekennzeichnet, dass die Leistungshalbleiterbaugruppen auf jeder Seite des Kühlkörpers eine Hälfte eines Halbbrückenmoduls bilden. Die Leistungshalbleiterbaugruppen umfassen vorzugsweise ein Substrat, auf welches mindestens ein Leistungshalbleiterschalter mit antiparalleler Diode aufgebracht ist. Der Kühlkörper wird vorteilhafterweise von einer Kühlflüssigkeit durchflossen, und die ganze Anordnung wird in ein Schutzgehäuse integriert.

Weitere Ausführungsbeispiele ergeben sich aus den entsprechenden Unteransprüchen.

Der Vorteil des erfindungsgemässen Aufbaus besteht insbesondere darin, dass das Modul eine ausreichende Kühlung aufweist, denn auf beiden Seiten des Kühlkörpers sind Baugruppen angebracht und die Baugruppen werden direkt auf den Kühlkörper montiert. Damit entfällt gegenüber bekannten Modulen der Wärmeübergang vom Modul zum Kühler.

Die Verwendung von Platten zur Kontaktierung, die zudem auf der Gleichspannungsseite keine Umlenkung des Stromes erfordern, ermöglicht es, die Induktivität minimal zu halten. Damit kann auch innerhalb des Moduls bzw. der Baugruppe eine grosse Anzahl kleinflächiger Bauelemente problemlos parallelgeschaltet werden.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Die Schaltungsanordnung einer Halbbrücke;
- **Fig. 2**: Ein erfindungsgemässes Leistungshalbleitermodul im Schnitt; und
- **Fig. 3**: Eine Aufsicht auf eine Leistungshalbleiterbaugruppe.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

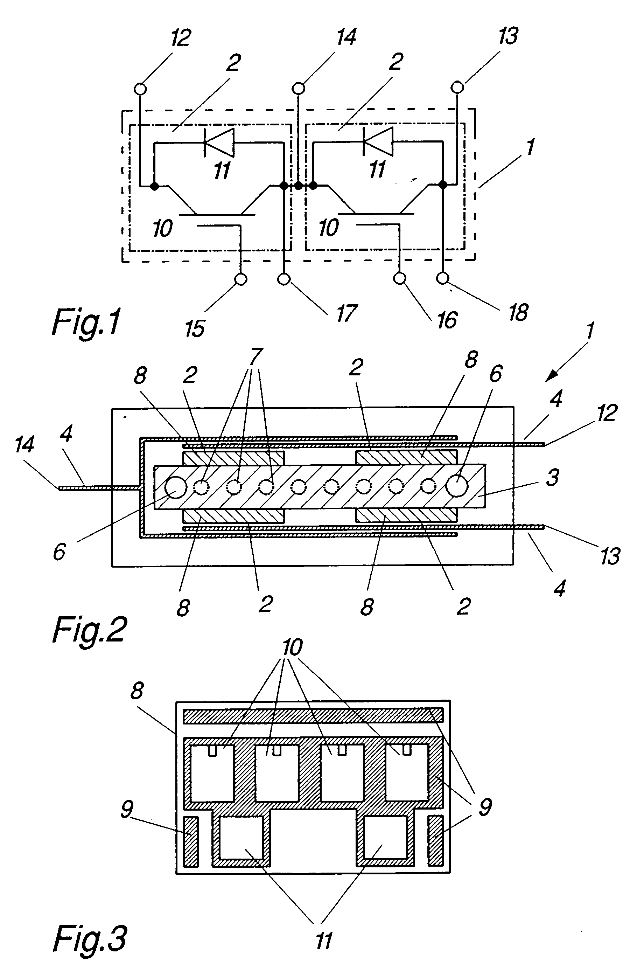

Eine der Hauptanwendungen von schaltbaren Hochleistungs-Bauelementen sind Inverterschaltungen zur Erzeugung von Wechselspannung aus einer Gleichspannung. Für diese Anwendung werden pro Phase jeweils zwei Schalter und dazugehörige Dioden benötigt. Diese sogenannte Halbbrücke stellt den kleinsten logischen Baustein für eine Inverterschaltung dar. Ein solche Halbbrücke ist in Figur 1 dargestellt.

Für höchste Leistungen kann bis heute eine Halbbrücke nur aus zwei Einzelschaltmodulen zusammengesetzt werden, da die Integration der gesamte Funktion in nur ein Modul zu einem sehr grossflächigen Modul führen würde, was aufgrund der vorne erläuterten Begrenzungen nicht möglich ist.

Gegenstand der Erfindung ist daher ein Halbbrückenmodul, das für höchste Leistungen geeignet ist. Ein solches Modul ist in **Figur 2** im Schnitt dargestellt. Es umfasst einen Kühlkörper (3), der von Kühlkanälen (7) durchzogen ist und Anschlüsse (6) für ein Kühlmedium (z.B. Wasser mit Frostschutz-Zusatz) aufweist. Auf beiden Seiten des Kühlkörpers (3) sind Substrate (8) angebracht. Die Substrate (8) bestehen aus einem elektrisch isolierenden aber dennoch gut wärmeleitfähigen Material wie z.B. Aluminiumoxid, Aluminiumnitrid oder Beryliumoxid. Je nach Material des Kühlkörpers werden diese Substrate entweder aufgelötet (z.B. DCB Aluminiumoxidkeramik auf Kupfer) oder aufgeklebt (z.B. Aluminiumnitridkeramik auf Aluminium). Auch andere Verbindungstechniken wie Plasmaspritzen sind denkbar.

Jeweils auf der Oberseite der Substrat (8) werden bereits vorher die einzelnen Bauelemente (z.B. IGBTs und Dioden) montiert, miteinander verbunden und vorgetestet. Eine Aufsicht auf ein solches bestücktes Substrat (8) ist in **Figur 3** dargestellt.

Im einem realisierten Ausführungsbeispiel umfassen die montierten Bauteile jedes Substrats die Funktion eines Leistungshalbleiterschalters (10) mit antiparallel geschalteter Diode (11). Der Leistungshalbleiterschalter (10) und die Diode (11) können ihrerseits aus mehreren diskreten Bauelementen zusammengesetzt sein. Im allgemeinen Fall bildet ein bestücktes Substrat (8) ein Leistungshalbleiterbaugruppe (2) mit im Prinzip beliebiger Funktion.

Diese Leistungshalbleiterbaugruppen (2) werden nun mittels geeignet geformter, elektrisch leitender Kontaktbleche (4) kontaktiert. Die Bleche (4) bestehen vorzugsweise aus dem gleichen oder einem bezüglich des thermischen Ausdehnungskoeffizienten an den Kühlkörper (3) angepassten Werkstoff. Zwischen den einzelnen Blechen (4) sind nicht dargestellte Isolierplatten eingelegt. Die Kontaktbleche (4) und die Isolierplatten werden zu einem Stapel verbunden (z.B. verklebt) und mit dem Kühlkörper (3) mechanisch verbunden.

Diese Blechpakete dienen nun auf beiden Seiten der Kühlkörper (3) zur niederinduktiven Verbindung der einzelnen Substrate (8). Die Substrate werden mit Hilfe von Bond- oder Lötverbindungen (je nach Werkstoff der Bleche) an das jeweilige Blechpaket angeschlossen.

Im aufgebauten Ausführungsbeispiel stellten die Substrate (8) auf jeder Seite des Kühlkörpers (3) die erwähnte Einzelschaltereinheit dar. Demzufolge umfasste jede Seite des Kühlkörpers (3) eine "Viertelbrücke" und das gesamte Modul (1) stellte eine Halbbrücke dar. Wie Figur 1 zu entnehmen ist, weist eine solche Halbbrücke einen Plusanschluss (12), einen Minusanschluss (13) und einen Wechselspannungsanschluss (14) auf. Die Schalter (10) werden über einen Steueranschluss (15, 16) ein- und ausgeschaltet. Zur Fehlerüberwachung kann ausserdem je ein Messanschluss (17, 18) vorgesehen sein. Demzufolge umfasst das Kontaktblechpaket zur Kontaktierung eines solchen Halbbrückenmoduls (1) die entsprechende Anzahl Kontaktbleche (4).

Vorzugsweise werden die Kontaktbleche (4) für die Hauptanschlüsse (Plus-, Minus-, AC-Anschluss) wie Figur 2 dargestellt angeordnet. Von der einen Seite werden die Gleichspannungsanschlüsse (12 u. 13) herangeführt, von der anderen Seite der Wechselspannungsanschluss (14). Dieser bildet gleichzeitig die Verbindung zwischen den auf verschiedenen Seiten des Kühlkörpers (3) angeordneten Viertelbrücken.

Auf den Substraten (8) sind zur Kontaktierung der Bauelemente (10 und 11) mit den Kontaktblechen (4) entweder Leiterbahnen (9) aufgebracht oder die Bauelemente werden direkt mit den Kontaktblechen (4) verbunden. Im Falle des realisierten Moduls wurde die Verbindung der Kathode der Diode (11) mit dem einer Anode entsprechenden Anschluss des Leistungshalbleiterschalters (10) direkt dadurch hergestellt, dass die beiden Bauelemente mit ihren Unterseiten auf das Substrat gelötet wurden.

Schliesslich wird das so entstandene Modul (1) gegen Einwirkungen von aussen geschützt, indem es mit einem Gehäuse (5) versehen und z.B. mit einem Silikon-Gel vergossen wird.

Da die beiden Gleichspannungsanschlüsse (12, 13) nicht wie bei herkömmlichen Modulen nebeneinander sondern übereinander liegen, entsteht keine Stromschleife und damit keine zusätzliche Induktivität. Ist die Gleichspannungsversorgung ebenfalls, wie es im übrigen dem heutigen Stand der Technik entspricht, in Form übereinanderliegender Platten ausgeführt, so kann das Modul optimal mittels Schraub-, bevorzugterweise aber Steckverbindungen, angeschlossen werden. Das gezeigte Ausführungsbeispiel geht von einer Steckverbindung auf der DC-Seite aus. Der Mittelsteg aus isolierendem Material führt den Stecker (z.B. keilförmig) und sorgt gleichzeitig für die Einhaltung der notwendigen Kriechwege.

Ein solches Modul (1) erfüllt nun alle Forderungen, die an eine Halbbrückenmodul oder allgemein an ein Leistungshalbleitermodul höchster Leistung gestellt werden:
- Ausreichende Kühlung: Dadurch, dass die Bauelemente elektrisch isoliert direkt auf einen Kühlkörper (3) montiert werden, entfällt gegenüber Modulen nach dem Stand der Technik der Wärmeübergang vom Modul zum Kühler. Der für das realisierte Modul berechnete und experimentell bestätigte Wärmewiderstand zwischen Sperrschicht und Kühlmedium liegt etwa einen Faktor zwei unter dem Wert, der heute für konventionelle Module erzielbar ist. Dieser Wert ist damit auch geringer als derjenige kommerziell erhältlicher Scheibenzellen.
- Niederinduktiver Aufbau: Die Verwendung von Platten, die zudem auf der Gleichsspannungsseite (dort ist die Induktivität kritisch) keine Umlenkung des Stromes erfordern, ermöglicht es, die Induktivität minimal zu halten. Damit kann auch problemlos eine Anzahl kleinflächiger Bauelemente parallelgeschaltet werden.
- Baugrösse, thermische Wechselfestigkeit: Die Bestückung des Kühlkörpers von beiden Seiten erlaubt eine minimale Baugrösse und eine optimale Ausnutzung der zur Verfügung gestellten Kühlfläche. Die Vermeidung grosser Berührungsflächen (kleines Substrat, typischerweise 10cm²) sowie die sorgfältige Abstimmung der für Kühler, Verbindungstechnik und Plattenstapel verwendeten Werkstoffe sorgen dafür, dass die aufgrund der unterschiedlichen thermischen Ausdehnungskoeffizienten auftretenden Kräfte minimal sind. Dadurch wird eine ausgezeichnete Lastwechselfestigkeit erzielt.
- Isolation, Kriechwege: Die vorgeschlagene Bauform ermöglicht es, entsprechend den gültigen Normen isolierende Materialien in genügender Dicke und Abmessung so einzubauen, dass stromführende Kontakte vom Kühlkörper und den Steuer- und Messanschlüssen genügend Abstand haben. Dies erfordert keinen Kompromiss zu den sonst vom Halbbrückenmodul geforderten Eigenschaften.
- Mechanische und elektrische Verbindung zum Schaltkreis: Da der Kühler bereits in das Modul eingebaut ist, kann das Modul waagrecht oder senkrecht stehend eingebaut werden. Es muss nicht der vorgegebenen Geometrie einer Halte- und/oder Kühlplatte folgen. Vorteilhaft ist die mechanische Fixierung des Moduls in Führungsschienen, in die das Module aufgenommen wird und dann in einer Endposition einrastet.

Selbstverständlich ist der erläuterte Aufbau eines Leistungshalbleitermoduls nicht nur auf Halbbrücken-Schaltungsanordnungen beschränkt, sondern wird auch mit Vorteil für andere Funktionen verwendet.

### Bezeichnungsliste

- 1: Leistungshalbleitermodul
- 2: Leistungshalbleiterbaugruppe
- 3: Kühlkörper
- 4: Kontaktblech
- 5: Gehäuse
- 6: Kühlflüssigkeitsanschluss
- 7: Kühlkanal
- 8: Substrat
- 9: Leiterbahn
- 10: Leistungshalbleiterschalter
- 11: Diode
- 12: Plusanschluss
- 13: Minusanschluss
- 14: Wechselspannungsanschluss
- 15, 16: Steueranschlüsse
- 17, 18: Messanschlüsse

## Patentansprüche

1. Leistungshalbleitermodul (1) mit einem Kühlkörper mit zwei Oberflächen und vier Seitenflächen (3), wobei auf beiden Oberflächen des Kühlkörpers (3) mindestens eine Leistunghalbleiterbaugruppe (2), welche mit ihrer Unterseite auf der Oberfläche des Kühlkörpers befestigt ist, vorgesehen ist; wobei die Leistungshalbleiterbaugruppen (2) von parallel zu den Oberflächen des Kühlkörpers (3) erstreckenden, aufeinander gestapelten, untereinander isolierten, elektrisch leitenden Kontaktblechen (4) kontaktiert werden.

2. Leistungshalbleitermodul (1) nach Anspruch 1, dadurch gekennzeichnet, dass die Leistungshalbleiterbaugruppen (2) mindestens einen Leistungshalbleiterschalter (10), insbesondere einen IGBT, mit antiparallel geschalteter Diode (11) umfassen, welche auf ein Substrat (8) aus elektrisch isolierendem aber gut wärmeleitenden Material, insbesondere aus Aluminiumoxid, Aluminiumnitrid oder Beryliumoxid aufgebracht sind.

3. Leistungshalbleitermodul (1) nach Anspruch 2, dadurch gekennzeichnet, dass die Anodenanschlüsse der Dioden (11) der auf der einen Seite des Kühlkörpers (3) angebrachten Leistungshalbleiterbaugruppen (2) über ein entsprechendes Kontaktblech (4) mit dem Plusanschluss (12) einer Gleichspannungsquelle, die Kathodenanschlüsse der Dioden (11) der auf der anderen Seite des Kühlkörpers (3) angebrachten Leistungshalbleiterbaugruppen (2) über ein weiteres Kontaktblech (4) mit dem Minusanschluss (13) der Gleichspannungsquelle und die Kathoden- bzw. Anodenanschlüsse der Dioden (11) der jeweils anderen Seite über ein gemeinsames Kontaktblech (4) mit einem Wechselspannungsanschluss (14) verbunden sind.

4. Leistungshalbleitermodul (1) nach Anspruch 3, dadurch gekennzeichnet, dass
- auf dem Substrat (8) Leiterbahnen (9) für die Anschlüsse der Leistungshalbleiterschalter (10) und die Dioden (11) vorgesehen sind;
- die Kathodenanschlüsse der Dioden (11) und die einer Anode entsprechenden Anschlüsse der Leistungshalbleiterschalter (10) direkt auf das Substrat angebracht sind.

5. Leistungshalbleitermodul nach Anspruch 4, dadurch gekennzeichnet, dass die übrigen Anschlüsse der Leistunghalbleiterschalter (10) und Dioden (11), insbesondere die Anodenanschlüsse der Dioden (11), Steueranschlüsse (15, 16), Messanschlüsse (17, 18) sowie die einer Kathode entsprechenden Anschlüsse der Leistungshalbleiterschalter (10), mit weiteren Leiterbahnen (9) verbunden sind, welche Leiterbahnen (9) ihrerseits mit entsprechenden Kontaktblechen (4) verbunden sind.

6. Leistungshalbleitermodul (1) nach Anspruch 4, dadurch gekennzeichnet, dass die übrigen Anschlüsse der Leistunghalbleiterschalter (10) und Dioden (11), insbesondere die Anodenanschlüsse der Dioden (11), Steueranschlüsse (15, 16), Messanschlüsse (17, 18) sowie die einer Kathode entsprechenden Anschlüsse der Leistungshalbleiterschalter (10), direkt mit den entsprechenden Kontaktblechen (4) verbunden sind.

7. Leistungshalbleitermodul (1) nach einem der vorstehenden Ansprüche, dadurch gekennzeichnet, dass der Kühlkörper (3) von einer Kühlflüssigkeit durchflossen wird und entsprechende Kühlflüssigkeitsanschlüsse (6) und Kühlkanäle (7) im Kühlkörper (3) vorgesehen sind.

8. Leistungshalbleitermodul (1) nach einem der vorstehenden Ansprüche, dadurch gekennzeichnet, dass die Kontaktbleche (4) aus einem Werkstoff bestehen, dessen thermischer Ausdehnungskoeffizient demjenigen des Kühlkörpers (3) angepasst ist.

9. Leistungshalbleitermodul (1) nach einem der vorstehenden Ansprüche, dadurch gekennzeichnet, dass der Kühlkörper (3) mit den Leistungshalbleiterbaugruppen (2) und den Kontaktblechen (4) von einem Schutzgehäuse (5) umgeben ist, wobei die Kontaktbleche(4) als Modulanschlüsse aus dem Gehäuse (5) hinausgeführt sind.

10. Leistungshalbleitermodul (1) nach einem der vorstehenden Ansprüche, dadurch gekennzeichnet, dass zwischen den Kontaktblechen (4) Isolierplatten eingelegt sind.

## Claims

1. Power semiconductor module (1) having a heat sink with two surfaces and four side areas (3), at least one power semiconductor assembly (2) being provided on both surfaces of the heat sink (3), the bottom of which assembly is mounted on the surfaces of the heat sink, in which case the the power semiconductor assemblies (2) are made contact with directly by electrically conductive contact laminates (4), which extend parallel to the surfaces of the heat sink (3), are stacked on one another and are insulated from one another.

2. Power semiconductor module (1) according to Claim 1, characterized in that the power semiconductor assemblies (2) comprise at least one power semiconductor switch (10), in particular an IGBT, having a reverse-connected parallel diode (11), which are fitted to a substrate (8) made of an electrically insulating, but readily thermally conductive, material, in particular made of aluminium oxide, aluminium nitride or beryllium oxide.

3. Power semiconductor module (1) according to Claim 2, characterized in that the anode connections of the diodes (11) of the power semiconductor assemblies (2), fitted on the one side of the heat sink (3), are connected to the positive connection (12) of a DC voltage source via a corresponding contact laminate (4), the cathode connections of the diodes (11) of the power semiconductor assemblies (2), fitted on the other side of the heat sink (3), are connected to the negative connection (13) of the DC voltage source via a further contact laminate (4), and the cathode and anode connections, respectively, of the diodes (11) on the respective other side are connected to an AC voltage connection (14) via a common contact laminate (4).

4. Power semiconductor module (1) according to Claim 3, characterized in that
- conductor tracks (9) for the connections of the power semiconductor switches (10) and the diodes (11) are provided on the substrate (8);
- the cathode connections of the diodes (11) and the connections, corresponding to an anode, of the power semiconductor switches (10) are fitted directly onto the substrate.

5. Power semiconductor module according to Claim 4, characterized in . that the remaining connections of the power semiconductor switches (10) and diodes (11), in particular the anode connections of the diodes (11), control connections (15, 16), measuring connections (17, 18) as well as the connections, corresponding to a cathode, of the power semiconductor switches (10), are connected to further conductor tracks (9), which conductor tracks (9) are connected for their part to corresponding contact laminates (4) .

6. Power semiconductor module (1) according to Claim 4, characterized in that the remaining connections of the power semiconductor switches (10) and diodes (11), in particular the anode connections of the diodes (11), control connections (15, 16), measuring connections (17, 18) as well as the connections, corresponding to a cathode, of the power semiconductor switches (10), are directly connected to the corresponding contact laminates (4).

7. Power semiconductor module (1) according to one of the preceding claims, characterized in that a cooling liquid flows through the heat sink (3) and corresponding cooling liquid connections (6) and cooling channels (7) are provided in the heat sink (3).

8. Power semiconductor module (1) according to one of the preceding claims, characterized in that the contact laminates (4) are composed of a material which has a thermal expansion coefficient matched to that of the heat sink (3).

9. Power semiconductor module (1) according to one of the preceding claims, characterized in that the heat sink (3) with the power semiconductor assemblies (2) and the contact laminates (4) is surrounded by a protective casing (5), the contact laminates (4) being routed as module connections out of the casing (5).

10. Power semiconductor module (1) according to one of the preceding claims, characterized in that insulating plates are inserted between the contact laminates (4) .

## Revendications

1. Module semi-conducteur de puissance (1) composé d'un radiateur ayant deux surfaces et quatre faces latérales (3), au moins un élément semi-conducteur de puissance (2) dont le côté inférieur est fixé sur la surface du radiateur (3) étant prévu sur les deux surfaces du radiateur; les éléments semi-conducteurs de puissance (2) étant mis en contact direct par des tôles de contact (4) conductrices d'électricité empilées les unes sur les autres, isolées entre elles et s'étendant parallèlement aux surfaces du radiateur (3).

2. Module semi-conducteur de puissance (1) selon la revendication 1, caractérisé par le fait que les éléments semi-conducteurs de puissance (2) comprennent au moins un commutateur semi-conducteur de puissance (10), notamment un IGBT, avec une diode (11) branchée en antiparallèle, lesquels sont montés sur un substrat (8) en matériau isolant électrique mais bon conducteur de chaleur, notamment en oxyde d'aluminium, en nitrure d'aluminium ou en oxyde de béryllium.

3. Module semi-conducteur de puissance (1) selon la revendication 2, caractérisé par le fait que les bornes des anodes des diodes (11) des éléments semi-conducteurs de puissance (2) montés sur l'un des côtés du radiateur (3) sont reliées par une tôle de contact (4) correspondante à la borne positive (12) d'une source de tension continue, les bornes des cathodes des diodes (11) des éléments semi-conducteurs de puissance (21) montés de l'autre côté du radiateur (3) sont reliées par une autre tôle de contact (4) à la borne négative (13) de la source de tension continue et les bornes des cathodes ou des anodes des diodes (11) des côtés opposés respectifs sont reliées à une borne de tension alternative (14) par le biais d'une tôle de contact commune (4).

4. Module semi-conducteur de puissance (1) selon la revendication 3, caractérisé par le fait que
- des pistes conductrices (9) destinées au raccordement du commutateur semi-conducteur de puissance (10) et les diodes (11) sont prévues sur le substrat (8) ;
- les bornes des cathodes des diodes (11) et les bornes correspondant à une anode du commutateur semi-conducteur de puissance (10) sont montées directement sur le substrat.

5. Module semi-conducteur de puissance selon la revendication 4, caractérisé par le fait que les autres bornes du commutateur semi-conducteur de puissance (10) et des diodes (11), notamment les bornes des anodes des diodes (11), les bornes de commande (15, 16), les bornes de mesure (17, 18) ainsi que les bornes correspondant à une anode du commutateur semi-conducteur de puissance (10) sont reliées à d'autres pistes conductrices (9), lesdites pistes conductrices (9) étant de leur côté reliées aux tôles de contact (4) correspondantes.

6. Module semi-conducteur de puissance (1) selon la revendication 4, caractérisé par le fait que les autres bornes du commutateur semi-conducteur de puissance (10) et des diodes (11), notamment les bornes des anodes des diodes (11), les bornes de commande (15, 16), les bornes de mesure (17, 18) ainsi que les bornes correspondant à une anode du commutateur semi-conducteur de puissance (10) sont reliées directement aux tôles de contact (4) correspondantes.

7. Module semi-conducteur de puissance (1) selon l'une des revendications précédentes, caractérisé par le fait que le radiateur (3) est traversé par un liquide de refroidissement et que des raccords pour liquide de refroidissement (6) correspondants et des canaux de refroidissement (7) correspondants sont prévus en conséquence dans le radiateur (3).

8. Module semi-conducteur de puissance (1) selon l'une des revendications précédentes, caractérisé par le fait que les tôles de contact (4) sont composées d'un matériau dont le coefficient de dissipation thermique est adapté à celui du radiateur (3).

9. Module semi-conducteur de puissance (1) selon l'une des revendications précédentes, caractérisé par le fait que le radiateur (3) ainsi que les éléments semi-conducteurs de puissance (2) et les tôles de contact (4) sont entourés par un boîtier de protection (5), les tôles de contact (4) étant sorties du boîtier (5) pour faire office de bornes du module.

10. Module semi-conducteur de puissance (1) selon l'une des revendications précédentes, caractérisé par le fait que des plaques isolantes sont intégrées entre les tôles de contact (4).
